(19)

Europäisches
Patentamt
European
Patent Office
Office européen
des brevets

(11)  **EP 3 578 467 A1**

(12)  **EUROPEAN PATENT APPLICATION**

(43) Date of publication:
**11.12.2019  Bulletin 2019/50**

(51) Int Cl.:
**B64G 7/00** *(2006.01)*  **B64G 99/00** *(2009.01)*
**G06F 17/50** *(2006.01)*  **B64G 1/62** *(2006.01)*

(21) Application number: **19152964.3**

(22) Date of filing: **22.01.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.06.2018  KR 20180063148**

(71) Applicant: **Korea Astronomy And Space Science
Institute
Yuseong-gu, Daejeon 34055 (KR)**

(72) Inventor: **CHOI Eun Jung
34071 Daejeon (KR)**

(74) Representative: **TBK
Bavariaring 4-6
80336 München (DE)**

(54)  **METHOD FOR RE-ENTRY PREDICTION OF UNCONTROLLED ARTIFICIAL SPACE OBJECT**

(57)   The present invention relates to a method for re-entry prediction of an uncontrolled artificial space object, the method including: calculating an average semi-major axis and an argument of latitude by inputting two-line elements or osculating elements of an artificial space object at two different time points; calculating an average semi-major axis, argument of latitude, and atmospheric drag at a second time point; estimating an optimum drag scale factor while changing the drag scale factor; predicting the time and place of re-entry of an artificial space object into the atmosphere by applying the estimateddrag scale factor. Here, orbit prediction is performed by using a Cowell's high-precision orbital propagator using numerical integration from the second time point to a re-entry time point.

**FIG. 1**

**Description**

CROSS REFERENCE TO RELATED APPLICATION

The present application claims priority to Korean Patent Application No. 10-2018-0063148, filed June 10, 2018, the entire contents of which is incorporated herein for all purposes by this reference.

BACKGROUND OF THE INVENTION

Technical Field

The present invention relates to a method for re-entry prediction of an artificial space object and, more particularly, to a method for re-entry prediction of an uncontrolled artificial space object by using a drag scale factor estimation (DSFE) method.

Background Art

The re-entry of an uncontrolled artificial space object of 1 ton or more is highly likely to cause damage to the ground. Therefore, the domestic response manual for a crash and collision of an artificial space object specifies that a crisis alert for the re-entry status of the space object is issued when an artificial space object reaches an altitude of 250 km or less. Accordingly, it is very important to provide accurate re-entry prediction information quickly in order to predict the re-entry status and risk of damage by artificial space objects.

Particularly, when artificial space objects fall and reach an altitude of 250 km, the artificial space objects begin the re-entry process into the atmosphere within about one month, and at the re-entry of an artificial space object with a weight of 1 ton or more, fragments of about 10 to 40% of the artificial space object reach the earth's surface. Particularly, the re-entry of an uncontrolled artificial space object is difficult to predict, which results in loss of lives and assets on the ground. Therefore, to prepare for the re-entry risk of space objects, a technique of predicting the re-entry risk of space objects is necessary to minimize such risk.

A method for re-entry prediction of an uncontrolled artificial space object in the related art is configured to predict a re-entry time point by using the simplified general perturbations 4 (SGP4) orbit propagator using two-line elements (TLE). However, when comparing the predicted re-entry time point with actual re-entry estimation time point and place, the prediction accuracy is very low, whereby there is a problem of not being applied to the re-entry status of the actual space object.

SUMMARY OF THE INVENTION

In order to solve the above problems, the object of the present invention is to provide a method for re-entry prediction of an uncontrolled artificial space object which is configured to accurately predict an expected time point and place of a re-entry of the space object by using a drag scale factor estimation (DSFE) method.

In order to achieve the above object, an embodiment of the present invention provides a method for re-entry prediction of an uncontrolled artificial space object, the method includes: calculating an average semi-major axis and an argument of latitude by inputting two-line elements (TLE) or osculating elements of the artificial space object at two different time points; calculating an average semi-major axis, an argument of latitude, and an atmospheric drag at a second time point of the two different time points by performing orbital propagation with a Cowell's high-precision orbital propagator using numerical integration up to the second time point, the orbital propagation being performed by applying an initial drag scale factor, which is an arbitrary constant, to orbit information at the first time point; estimating an optimum drag scale factor while changing the drag scale factor until error becomes smaller than a random convergence value by comparing the predicted average semi-major axis or the argument of latitude with a preset average semi-major axis or a preset argument of latitude at the second time point; and predicting time and place of re-entry of the artificial space object into the atmosphere by performing orbit prediction with the Cowell's high-precision orbital propagator using numerical integration from the second time point to a re-entry time point and being applied with the estimated drag scale factor.

The two-line elements (TLE) may be converted into the osculating elements and an average orbit may be calculated in a true-of-date (TOD) coordinate system.

The convergence value may be a position error arbitrarily determined by a user.

As described above, according to the present invention, the atmospheric re-entry time and place of an uncontrolled artificial space object can be precisely predicted by using the DSFE method.

BRIEF DESCRIPTION OF THE DRAWINGS

The above and other objects, features and other advantages of the present invention will be more clearly understood from the following detailed description when taken in conjunction with the accompanying drawings, in which:

FIG. 1 is a flowchart illustrating a method for re-entry prediction of an uncontrolled artificial space object according to a first embodiment of the present invention;

FIG. 2 is a flowchart illustrating a method for re-entry prediction of an uncontrolled artificial space object according to a second embodiment of the present invention; and

FIG. 3 is a flowchart illustrating a method for re-entry prediction of an uncontrolled artificial space object according to a third embodiment of the present invention.

## DETAILED DESCRIPTION OF THE INVENTION

Hereinafter, exemplary embodiments of the present invention will be described in detail with reference to the accompanying drawings, which will be readily apparent to those skilled in the art to which the present invention pertains for the convenience of the person skilled in the art to which the present invention pertains. The present invention may, however, be embodied in many different forms and should not be construed as limited to the embodiments set forth herein.

Hereinafter, a method for re-entry prediction of an uncontrolled artificial space object according to embodiments of the present invention will be described.

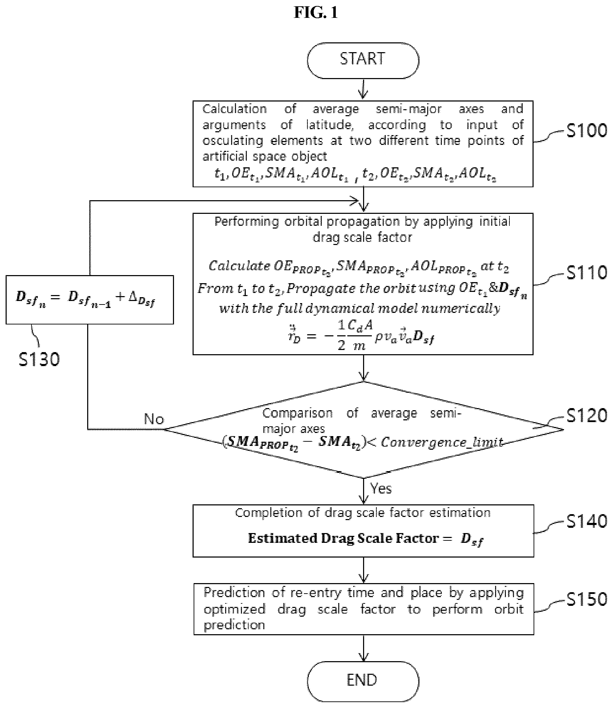

FIGS. 1 to 3 are flowcharts illustrating a method for re-entry prediction of an uncontrolled artificial space object according to first to third embodiments of the present invention, respectively.

Referring to FIGS. 1 to 3, in the method for re-entry prediction of an uncontrolled artificial space object according to the present invention, first, at step S100, S200, or S300, the average semi-major axes $SMA_{t1}$ and $SMA_{t2}$ and the arguments of latitude $AOL_{t1}$ and $AOLt_2$ of the artificial space object are calculated by inputting initial orbital elements $OE_{t1}$ and $OE_{t2}$ at two different time points $t_1$ and $t_2$. Here, the orbital elements may be osculating elements or two-line elements (TLE). When the orbital elements are the two-line elements, the two-line elements are converted into osculating elements and the osculating elements may be used to calculate an average orbit in a TOD (True of Date) coordinate system.

Next, at step S110, S210, or S310, orbit propagation is performed up to the second time point $t_2$ by applying an initial Drag Scale factor $D_{sf0}$, which is an arbitrary constant, to the orbit information of the first time point $t_1$. At this time, the orbital propagation calculates the average semi-major axis $SMA_{PROP_{t_2}}$, argument of latitude $AOL_{PROP_{t_2}}$, and atmospheric drag

$$\vec{r}_D = -\frac{1}{2}\frac{C_d A}{m}\rho v_a \vec{v}_a D_{sf}$$

according to the orbital element $OE_{PROP_{t_2}}$ at the second time point $t_2$ predicted by a Cowell's high-precision orbital propagator using numerical integration, wherein $C_d$ is a drag coefficient, A is a cross-sectional area, m is the mass, $\rho$ is a degree of tightness, $\vec{v}_a$ is a velocity vector, and $v_\alpha$ is a velocity vector size.

The Cowell's high-precision orbital propagator is an algorithm to obtain the position and velocity of an artificial space object at an arbitrary time based on the consideration of all perturbing forces such as earth's gravitational field, atmospheric influence, attraction of sun and moon, solar radiation pressure, etc. that affect artificial space objects. Since this technique is widely known in the field, detailed description will be omitted.

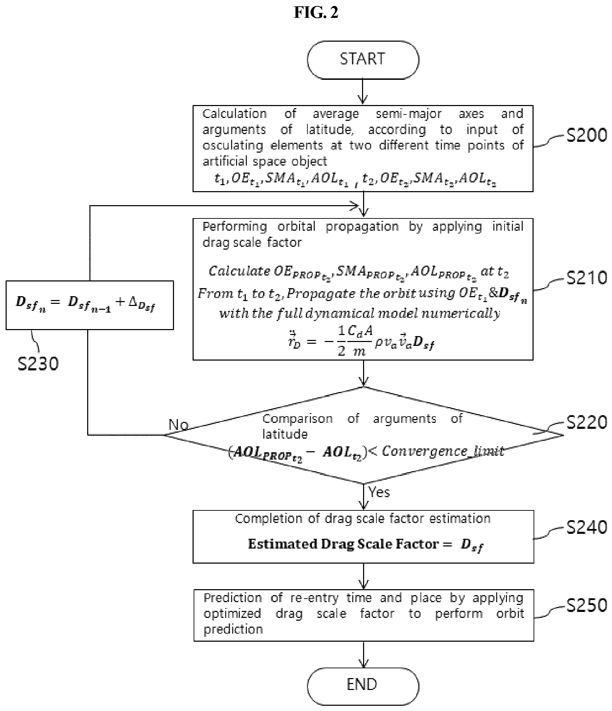

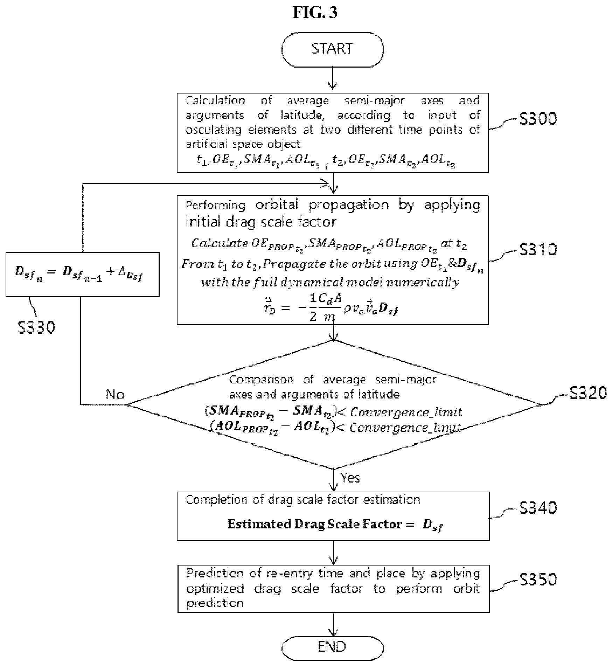

Next, when the error of a comparative value of average semi-major axes of FIG. 1, the error of a comparative value of arguments of latitude of FIG. 2, or the error of any one of the comparative value of average semi-major axis and the comparative value of arguments of latitude of FIG. 3 is compared with a convergence value at step S120, S220, or S320, and the error reaches a minimum, the optimal drag scale factor is determined at step S140, S240, or S340. If not, the procedure is repeated while changing the drag scale factor at step S130, S230, or S330. In other words, by comparing the average semi-major axis $SMAPROP_{t1}$ or argument of latitude value $AOL_{PROP_{t_1}}$ estimated by reflecting the drag scale factor $D_{sf}$ from the first time point $t_1$ to the second time point $t_2$ with the initially input average semi-major axis $SMA_{t2}$ or initially input argument of latitude value $AOL_{t2}$ at the second time point $t_2$, the optimum drag scale factor $D_{sf}$ is found while changing the drag scale factor until the error becomes smaller than the convergence value. Here, the convergence value is a position error, for example, $10^{-4}$ km and so on, which is set arbitrarily by a user.

Next, orbit prediction is performed by applying an optimized drag scale factor $D_{sf}$, through the Cowell's high-precision orbital propagator using numerical integration from the second time point $t_2$ to a re-entry time point. Thus, the accuracy of prediction of re-entry time and place within 100 km altitude is improved, and atmospheric re-entry time and place (latitude, longitude, and altitude) of an uncontrolled artificial space object are predicted at step S150, S250, or S350.

While the present invention has been particularly shown and described with reference to exemplary embodiments thereof, the scope of rights of the present invention is not limited thereto and various modifications and improvements of those skilled in the art using the basic concept of the present invention defined in the following claims are also within the scope of the present invention.

The present invention relates to a method for re-entry prediction of an uncontrolled artificial space object, the method including: calculating an average semi-major axis and an argument of latitude by inputting two-line elements or osculating elements of an artificial space object at two different time points; calculating an average semi-major axis, argument of latitude, and atmospheric drag at a second time point; estimating an optimum drag scale factor while changing the drag scale factor; predicting the time and place of re-entry of an artificial space object into the atmosphere by applying the estimated drag

scale factor. Here, orbit prediction is performed by using a Cowell's high-precision orbital propagator using numerical integration from the second time point to a re-entry time point.

## Claims

1. A method for re-entry prediction of an uncontrolled artificial space object, the method comprising:

calculating an average semi-major axis and an argument of latitude by inputting two-line elements (TLE) or osculating elements of the artificial space object at two different time points; calculating an average semi-major axis, an argument of latitude, and an atmospheric drag at a second time point of the two different time points by performing orbital propagation with a Cowell's high-precision orbital propagator using numerical integration up to the second time point, the orbital propagation being performed by applying an initial drag scale factor, which is an arbitrary constant, to orbit information at the first time point; estimating an optimum drag scale factor while changing the drag scale factor until error becomes smaller than a random convergence value by comparing the predicted average semi-major axis or the argument of latitude with a preset average semi-major axis or a preset argument of latitude at the second time point; and predicting time and place of re-entry of the artificial space object into the atmosphere by performing orbit prediction with the Cowell's high-precision orbital propagator using numerical integration from the second time point to a re-entry time point and being applied with the estimated drag scale factor.

2. The method according to claim 1, wherein the two-line elements (TLE) are converted into the osculating elements and an average orbit is calculated in a true-of-date (TOD) coordinate system.

3. The method according to claim 1, wherein the convergence value is a position error arbitrarily determined by a user.

**FIG. 1**

START

Calculation of average semi-major axes and arguments of latitude, according to input of osculating elements at two different time points of artificial space object
$t_1, OE_{t_1}, SMA_{t_1}, AOL_{t_1} , t_2, OE_{t_2}, SMA_{t_2}, AOL_{t_2}$ — S100

Performing orbital propagation by applying initial drag scale factor

Calculate $OE_{PROP_{t_2}}, SMA_{PROP_{t_2}}, AOL_{PROP_{t_2}}$ at $t_2$
From $t_1$ to $t_2$, Propagate the orbit using $OE_{t_1}$ & $D_{sf_n}$
with the full dynamical model numerically
$$\vec{r_D} = -\frac{1}{2}\frac{C_d A}{m}\rho v_a \vec{v_a} D_{sf}$$ — S110

$$D_{sf_n} = D_{sf_{n-1}} + \Delta_{D_{sf}}$$
S130

Comparison of average semi-major axes
$(SMA_{PROP_{t_2}} - SMA_{t_2}) <$ Convergence_limit — S120

No

Yes

Completion of drag scale factor estimation
**Estimated Drag Scale Factor $= D_{sf}$** — S140

Prediction of re-entry time and place by applying optimized drag scale factor to perform orbit prediction — S150

END

**FIG. 2**

START

Calculation of average semi-major axes and arguments of latitude, according to input of osculating elements at two different time points of artificial space object
$t_1, OE_{t_1}, SMA_{t_1}, AOL_{t_1}$ , $t_2, OE_{t_2}, SMA_{t_2}, AOL_{t_2}$ — S200

Performing orbital propagation by applying initial drag scale factor

Calculate $OE_{PROP_{t_2}}, SMA_{PROP_{t_2}}, AOL_{PROP_{t_2}}$ at $t_2$
From $t_1$ to $t_2$, Propagate the orbit using $OE_{t_1}$ & $D_{sf_n}$
with the full dynamical model numerically

$$\ddot{\vec{r}}_D = -\frac{1}{2}\frac{C_d A}{m}\rho v_a \vec{v}_a D_{sf}$$ — S210

$$D_{sf_n} = D_{sf_{n-1}} + \Delta_{D_{sf}}$$

S230

Comparison of arguments of latitude
$(AOL_{PROP_{t_2}} - AOL_{t_2}) < Convergence\_limit$ — S220

No ← → Yes

Completion of drag scale factor estimation
**Estimated Drag Scale Factor** $= D_{sf}$ — S240

Prediction of re-entry time and place by applying optimized drag scale factor to perform orbit prediction — S250

END

EP 3 578 467 A1

**FIG. 3**

START

Calculation of average semi-major axes and arguments of latitude, according to input of osculating elements at two different time points of artificial space object
$$t_1, OE_{t_1}, SMA_{t_1}, AOL_{t_1}, \; t_2, OE_{t_2}, SMA_{t_2}, AOL_{t_2}$$  — S300

Performing orbital propagation by applying initial drag scale factor
$$Calculate \; OE_{PROP_{t_2}}, SMA_{PROP_{t_2}}, AOL_{PROP_{t_2}} \; at \; t_2$$
$$From \; t_1 \; to \; t_2, Propagate \; the \; orbit \; using \; OE_{t_1} \& D_{sf_n}$$
$$with \; the \; full \; dynamical \; model \; numerically$$
$$\ddot{r}_D = -\frac{1}{2}\frac{C_d A}{m}\rho v_a \vec{v}_a D_{sf}$$  — S310

$$D_{sf_n} = D_{sf_{n-1}} + \Delta_{D_{sf}}$$
S330

Comparison of average semi-major axes and arguments of latitude
$$(SMA_{PROP_{t_2}} - SMA_{t_2}) < Convergence\_limit$$
$$(AOL_{PROP_{t_2}} - AOL_{t_2}) < Convergence\_limit$$  — S320

No

Yes

Completion of drag scale factor estimation
**Estimated Drag Scale Factor = $D_{sf}$**  — S340

Prediction of re-entry time and place by applying optimized drag scale factor to perform orbit prediction  — S350

END

7

Europäisches
Patentamt

European
Patent Office

Office européen
des brevets

# EUROPEAN SEARCH REPORT

Application Number

EP 19 15 2964

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAVID J. GONDELACH ET AL: "Ballistic Coefficient Estimation for Reentry Prediction of Rocket Bodies in Eccentric Orbits Based on TLE Data", MATHEMATICAL PROBLEMS IN ENGINEERING, vol. 2017, 1 January 2017 (2017-01-01), pages 1-13, XP55612058, CH ISSN: 1024-123X, DOI: 10.1155/2017/7309637 * the whole document * | 1-3 | INV. B64G7/00 B64G99/00 G06F17/50 ADD. B64G1/62 |
| A | JP 2001 116584 A (MITSUBISHI ELECTRIC CORP) 27 April 2001 (2001-04-27) * the whole document * | 1-3 | |
| A | WO 2007/084530 A2 (GLOBAL LOCATE INC [US]; ABRAHAM CHARLES [US] ET AL.) 26 July 2007 (2007-07-26) * the whole document * | 1-3 | |
| A | JEROME R. VETTER: "FIFTY YEARS OF ORBIT DETERMINATION: Fifty Years of Orbit Determination: Development of Modern Astrodynamics Methods", JOHNS HOPKINS APL TECHNICAL DIGEST, vol. 27, no. 3, 1 January 2007 (2007-01-01), pages 239-252, XP55612082, * the whole document * | 1-3 | TECHNICAL FIELDS SEARCHED (IPC) B64G G06F |
| A | C E VELEZ ET AL: "Time transformations and Cowell's method", JOURNAL OF CELESTIAL MECHANICS, vol. 17, no. 1, 1 January 1978 (1978-01-01), pages 83-99, XP55612079, DOI: 10.1007/BF01261054 * the whole document * | 1-3 | |

-/--

The present search report has been drawn up for all claims

| Place of search | Date of completion of the search | Examiner |
|---|---|---|
| Munich | 9 August 2019 | Weber, Carlos |

EPO FORM 1503 03.82 (P04C01)

page 1 of 2

Europäisches
Patentamt

European
Patent Office

Office européen
des brevets

# EUROPEAN SEARCH REPORT

Application Number

EP 19 15 2964

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ARRUN SAUNDERS ET AL: "Deriving Accurate Satellite Ballistic Coefficients from Two-Line Element Data", JOURNAL OF SPACECRAFT AND ROCKETS., vol. 49, no. 1, 1 January 2012 (2012-01-01), pages 175-184, XP55612070, US ISSN: 0022-4650, DOI: 10.2514/1.A32023 * the whole document * | 1-3 | |
| A | Eun-Jung Choi ET AL: "A Study on Re-entry Predictions of Uncontrolled Space Objects for Space Situational Awareness", Journal of Astronomy and Space Sciences, 31 December 2017 (2017-12-31), pages 289-302, XP55612085, DOI: 10.5140/JASS.2017.34.4.289 Retrieved from the Internet: URL:http://koreascience.or.kr/article/JAKO 201700352161745.page [retrieved on 2019-08-09] * the whole document * | 1-3 | TECHNICAL FIELDS SEARCHED (IPC) |

The present search report has been drawn up for all claims

| Place of search | Date of completion of the search | Examiner |
|---|---|---|
| Munich | 9 August 2019 | Weber, Carlos |

EPO FORM 1503 03.82 (P04C01)

## ANNEX TO THE EUROPEAN SEARCH REPORT
## ON EUROPEAN PATENT APPLICATION NO.

EP 19 15 2964

This annex lists the patent family members relating to the patent documents cited in the above-mentioned European search report.
The members are as contained in the European Patent Office EDP file on
The European Patent Office is in no way liable for these particulars which are merely given for the purpose of information.

09-08-2019

| Patent document cited in search report | | Publication date | Patent family member(s) | | Publication date |
|---|---|---|---|---|---|
| JP 2001116584 | A | 27-04-2001 | JP | 3978952 B2 | 19-09-2007 |
| | | | JP | 2001116584 A | 27-04-2001 |
| WO 2007084530 | A2 | 26-07-2007 | CN | 101351686 A | 21-01-2009 |
| | | | EP | 1979710 A2 | 15-10-2008 |
| | | | HK | 1129140 A1 | 05-10-2012 |
| | | | KR | 20080088569 A | 02-10-2008 |
| | | | US | 2007260399 A1 | 08-11-2007 |
| | | | US | 2009201196 A1 | 13-08-2009 |
| | | | US | 2015153455 A1 | 04-06-2015 |
| | | | WO | 2007084530 A2 | 26-07-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020180063148